# EUROPÄISCHE PATENTSCHRIFT

(11) **EP 2 766 507 B1**
(45) Veröffentlichungstag und Bekanntmachung des Hinweises auf die Patenterteilung: **15.06.2016**
(21) Anmeldenummer: 13701373.6
(22) Anmeldetag: 09.01.2013
(51) Int. Cl.: C23C 16/26, C23C 16/32, C23C 16/34, C23C 16/455

(54) **VERFAHREN ZUR CHEMISCHEN GASPHASENFILTRATION VON REFRAKTÄREN STOFFEN**
METHOD FOR THE CHEMICAL VAPOR INFILTRATION OF REFRACTIVE SUBSTANCES
PROCÉDÉ D'INFILTRATION CHIMIQUE EN PHASE GAZEUSE DE SUBSTANCES RÉFRACTAIRES

(30) Priorität: 10.01.2012 DE 102012100176
(43) Veröffentlichungstag der Anmeldung: 20.08.2014
(73) Patentinhaber: CVT GmbH & Co. Kg, 87642 Halblech (DE)
(72) Erfinder: HEGERMANN, Rainer, 87629 Füssen/Hopfen (DE); GOETZ, Philipp, 87642 Halblech (DE)
(74) Vertreter: Viering, Jentschura & Partner mbB Patent- und Rechtsanwälte
(86) Internationale Anmeldenummer: PCT/EP2013/050323
(87) Internationale Veröffentlichungsnummer: WO 2013/104685

(56) Entgegenhaltungen:
- EP-A1- 0 946 459
- EP-A2- 1 936 006
- US-A1- 2007 014 990

## Beschreibung

Die Erfindung betrifft ein Verfahren zur chemischen Gasphaseninfiltration von refraktären Stoffen, vorzugsweise von Kohlenstoff, Siliziumcarbid, Bornitrid, Titancarbid und dergleichen. Die Erfindung betrifft außerdem eine Vorrichtung zur Durchführung des erfindungsgemäßen Verfahrens sowie einen mittels des erfindungsgemäßen Verfahrens hergestellten infiltrierten Verbundwerkstoff.

Die Erfindung geht aus von einem Verfahren zur Gasphaseninfiltration, das in der EP 0 946 459 B1 beschrieben ist. Bei gegebener Temperatur in der Reaktionszone werden der Partialdruck des wenigstens einen gasförmigen Precursors und die Verweilzeit des Gases in der Reaktionszone derart eingestellt, dass in der porösen Struktur eine Abscheidungsreaktion des Precursors im Partialdruckbereich der Sättigungsadsorption erfolgt, und dass die Umsetzung des gasförmigen Precursors in jedem Stadium der Infiltration so begrenzt wird, dass beim Durchströmen der Reaktionszone nicht mehr als 50%, vorzugsweise 10% bis 25%, des im Gas zugeführten gasförmigen Precursors als feste Phase in der porösen Struktur abgeschieden werden. Hierdurch kann zu Gunsten hoher Abscheidungsgeschwindigkeiten bei hohen Porenfüllungsgraden mit wesentlich höheren Drücken und Partialdrücken der Eduktgase, beispielsweise im Bereich von 15 bis 25 kPa, als bei anderen bekannten Verfahren gearbeitet werden, die isotherm und isobar ablaufen. Die Beströmung der porösen Struktur soll gemäß der EP 0 946 459 B1 durch vertikale Spalte gleicher Spaltweite erfolgen. Hierbei ist jedoch nicht immer gewährleistet, dass der refraktäre Stoff durchgängig homogen und in einstellbarer Zieldichte abgeschieden wird.

Durch die WO 96/33295 ist ein Verfahren zur chemischen Infiltration in der Gasphase für die Verdichtung von porösen Substraten bekannt, die in ringförmigen Stapeln angeordnet sind. Um möglichst kurze Verweilzeiten der Gasphase zu erreichen, wird die Gasphase an der Eintrittsseite der Reaktionszone in den zentralen Innenraum des Stapels aus ringförmigen Scheiben eingeleitet und an der Austrittsseite der Reaktionszone aus dem den Stapel außen umgebenden Außenumfangsraum herausgeleitet. Der Außenumfangsraum ist zur Eintrittsseite hin geschlossen und der zentrale Innenraum ist zur Austrittsseite hin geschlossen. Dadurch sind die Querspalte, die zwischen den Scheiben ausgebildet sind, zwangsläufig in den Strömungsweg zwischen Einlass und Auslass der Reaktionszone eingeschaltet. Die Infiltration wird bei einer Temperatur von typisch 1000 °C und bei geringem Druck von typisch 1 kPa durchgeführt. Dieses bekannte Verfahren lässt sich jedoch wegen ganz erheblicher Gasphasennukleation, wie Rußbildung bei der Infiltration von Kohlenstoff, bei Verfahren erfindungsgemäßer Art nicht anwenden, bei welchen mit wesentlich höheren Drücken gearbeitet wird.

Durch die Erfindung wird erreicht, ein Verfahren zur chemischen Gasphaseninfiltration von refraktären Stoffen bereitzustellen, welches eine verbesserte Homogenität des in der porösen Struktur abgeschiedenen refraktären Stoffes ermöglicht. Weiterhin wird durch das erfindungsgemäße Verfahren ermöglicht, eine gewünschten Abscheidungsdichte (Zieldichte) des abgeschiedenen refraktionären Stoffes einzustellen.

Gemäß der Erfindung ist ein Verfahren bereitgestellt, bei dem zur chemischen Gasphaseninfiltration - auch CVI-Verfahren genannt - von wenigstens einem refraktären Stoff in einer Reaktionszone wenigstens eine poröse Struktur (im Folgenden auch Probenkörper oder Substrat genannt) mit einem wenigstens einen gasförmigen Precursor enthaltenden Gas beströmt wird. Bei gegebener Temperatur in der Reaktionszone werden der Partialdruck des gasförmigen Precursors und die Verweilzeit des Gases in der Reaktionszone derart eingestellt, dass in der porösen Struktur eine Abscheidungsreaktion des gasförmigen Precursors im Partialdruckbereich der Sättigungsadsorption erfolgt. Hierbei bedeutet Sättigungsadsorption, dass bei einer Erhöhung des Partialdruckes des wenigstens einen gasförmigen Precursors die Abscheidungsgeschwindigkeit im Wesentlichen konstant bleibt bzw. unwesentlich erhöht wird. Die Umsetzung des gasförmigen Precursors wird in jedem Stadium der Infiltration so begrenzt, dass beim Durchströmen der Reaktionszone nicht mehr als 50%, vorzugsweise 10% bis 25%, des im Gas zugeführten, nach der Infiltration eine feste Phase bildenden Precursors als die feste Phase in der porösen Struktur abgeschieden werden.

Die poröse Struktur wird in mindestens einem in Vertikalrichtung zwischen einer Eintrittsseite und einer Austrittsseite der Reaktionszone angeordneten vertikalen Stapel aus im Abstand übereinanderliegenden ringförmigen Schichten durch vertikale Umfangsspalte (A, B) aus wenigstens einem im horizontalen Querschnitt (im Querschnitt durch die Reaktionszone) ringförmigen radial äußeren Umfangsspalt (A) und wenigstens einem im horizontalen Querschnitt (im Querschnitt durch die Reaktionszone) ebenfalls ringförmigen radial inneren Umfangsspalt (B) wie auch durch quer zur Vertikalrichtung verlaufende Querspalte (C) zwischen den Schichten und querverlaufende Endspalte zwischen der Eintrittsseite beziehungsweise Austrittsseite der Reaktionszone und der jeweiligen Endschicht des Stapels beströmt. Die Querspalte und die querverlaufenden Endspalte sind jeweils zu dem radial äußeren Umfangsspalt wie auch zu dem radial inneren Umfangsspalt hin offen.

Gemäß der Erfindung ist weiter der radial äußere Umfangsspalt zu der Eintrittsseite und zu der Austrittsseite der Reaktionszone hin in seiner Längsrichtung offen, die vorzugsweise mit der Vertikalrichtung übereinstimmt, wohingegen der radial innere Umfangsspalt sowohl zu der Eintrittsseite als auch mit Vorteil zu der Austrittsseite hin in seiner Längsrichtung, die bevorzugt mit der Vertikalrichtung übereinstimmt, geschlossen ist. Hierbei ist das Verhältnis der Spaltweite des radial inneren Umfangsspaltes (B) zu der Spaltweite des radial äußeren Umfangsspaltes (A) größer 1 und kleiner gleich 20, und das Verhältnis der Spaltweite jedes der Querspalte (C) zur Spaltweite des radial äußeren Umfangsspaltes beträgt 0,25 bis 12.

Innerhalb dieser Spaltweitenverhältnisse kann variiert werden, wobei die Spaltweite des radial inneren Umfangsspalts (B) vorzugsweise stets größer als die Spaltweite jedes der Querspalte ist. Bevorzugt werden die Verhältnisse der Spaltweite des radial inneren Umfangsspaltes (B) zu der Spaltweite des radial äußeren Umfangsspaltes (A) sowie der Spaltweite der Querspalte (C) zu der Spaltweite des radial äußeren Umfangsspaltes (A) derart ausgewählt, dass das Verhältnis der Spaltweite des radial inneren Umfangsspalte (B) zu der Spaltweite jedes der Querspalte (C) im Bereich zwischen 1 und 10, bevorzugt zwischen 1 und 5 liegt. Wenn das Verhältnis von Außendurchmesser der ringförmigen Schichten des Stapels zu deren Innendurchmesser zunimmt, nimmt bei gleichbleibendem Spaltweitenverhältnis (B) zu (A) das Spaltweitenverhältnis (B) zu (C) bevorzugt ab.

Ein bevorzugtes Gesamtspaltverhältnis A:B:C beträgt 1:2:0,5 bis 1:10:5.

Gemäß der Erfindung kann mit vergleichsweise hohem Druck im Bereich von beispielsweise 100 bis 300 mbar, vergleichsweise kurzer Verweilzeit des Gases von beispielsweise 0,01 bis 0,9 s beim Durchtritt durch die Reaktionszone und mit vergleichsweise kurzer Infiltrations-Zeitdauer für die Ablagerung des refraktionären Stoffes in vorbestimmter Dichte bei weitestgehender Vermeidung von Gasphasennukleation gearbeitet werden. Durch die Größe der Spaltweite des radial inneren Umfangsspaltes relativ zu der Spaltweite des radial äußeren Umfangsspaltes, von dem der Stapel an seinem Außenumfang umgrenzt wird, wird der freie Durchtritt des Gases von dem radial äußeren Umfangsspalt durch die Querspalte bis in den radial inneren Umfangsspalt angetrieben, von dem der Stapel entlang seines inneren Umfangs begrenzt wird und dessen eintrittsseitiges Ende geschlossen ist. Durch die Größe der Spaltweite der Querspalte relativ zur Spaltweite des radial äußeren Umfangsspaltes wird die Abscheidungsdichte für die Abscheidung des refraktionären Stoffes in den Poren der porösen Struktur in den jeweils benachbarten Schichten des Stapels pro Infiltrations-Durchlauf bestimmt, so dass diese Abscheidungsdichte durch entsprechende Bemessung der Größe der Spaltweite der Querspalte auf eine gewünschte, weitestgehend homogene Zieldichte pro Durchgang des Gases durch die Reaktionszone eingestellt werden kann. Bei gleichbleibendem Spaltweitenverhältnis (B) zu (A) nimmt das bevorzugte Spaltweitenverhältnis (B) zu (C) ab, je kleiner die angestrebte homogene Abscheidungs-Zieldichte ist. Auch die Morphologie des abgelagerten Stoffes kann durch die Größe der Spaltweite der Querspalte beeinflusst werden.

Der radial äußere Umfangsspalt wie auch der radial innere Umfangsspalt sind an ihren Stellen zwischen den Querspalten jeweils im Querschnitt ringförmig und haben über ihre Länge hin zwischen den Querspalten jeweils eine Spaltweite, die in Umfangsrichtung des betreffenden Umfangsspaltes konstant ist. Bevorzugt sind die Spaltweiten der Umfangsspalte jeweils auch in Vertikalrichtung entlang der Innenseite beziehungsweise der Außenseite des Stapels konstant, wenngleich es möglich ist, die Spaltweite des radial inneren Umfangsspalt und/oder die Spaltweite des radial äußeren Umfangsspalt zur Beeinflussung des Ablagerungserfolgs innerhalb des erfindungsgemäßen Bereichs des Verhältnisses der Spaltweite des radial inneren Umfangsspaltes zu der des radial äußeren Umfangsspaltes in Vertikalrichtung von Querspalt zu Querspalt wenigstens entlang des Endabschnitts des Umfangsspaltes größer oder kleiner werden zu lassen.

Der radial innere Umfangsspalt wird an seinem Außenumfang von den radial inneren Seiten der Schichten des Stapels begrenzt und wird an seinem Innenumfang von einer Reaktorwand, insbesondere einem in den Stapel axial eingesetzten zentralen Kern begrenzt. Der radial äußere Umfangsspalt wird an seinem Innenumfang von den radial äußeren Seiten der Schichten des Stapels begrenzt und an seinem Außenumfang von einer Reaktorwand umgrenzt. Wenn daher mehrere Schichtenstapel nebeneinander in einem gemeinsamen Reaktorbehälter beströmt werden, wird jeder der Stapel von einer ihm zugeordneten gesonderten Reaktorwandung derart umgrenzt, dass die Spaltweite des radial äußeren Umfangsspaltes in Umfangsrichtung konstant ist.

Auch die Querspalte (C), die oben und unten von den im Stapel jeweils aufeinander folgenden Schichten des Stapels begrenzt werden, haben eine Spaltweite, die in Umfangsrichtung entlang des jeweiligen Radius konstant ist. Sie können hierbei auch in Radialrichtung vorzugsweise konstante und untereinander gleiche Spaltweiten aufweisen. Es kann jedoch auch vorteilhaft sein, dass die Spaltweiten der Querspalte (C) im Reaktor innerhalb des erfindungsgemäßen Bereichs des Verhältnisses der Spaltweite der Querspalte zu der des radial äußeren Umfangsspaltes unterschiedlich sind.

Das erfindungsgemäße Verfahren wird bevorzugt auf poröse Strukturen angewendet, die als die jeweilige Schicht bildende Ringscheiben ausgebildet sind, vorzugsweise eben sind und gleiche Außen- und Innendurchmesser haben und in der Reaktionszone axial und konzentrisch zueinander und im Abstand voneinander übereinander gestapelt sind, wobei die Querspalte (C) jeweils zwischen einander benachbarten Schichten senkrecht zu der Achse des Scheibenstapels ausgebildet sind..

Nicht-rotationssymmetrische Probenkörper können vorzugsweise entsprechend ringscheibenförmig und mit Abstandsstücken dazwischen in der jeweiligen Schicht angeordnet sein.

Die Spaltweite des radial inneren Umfangsspaltes zu der Spaltweite des radial äußeren Umfangsspaltes ist abhängig vom Durchmesser der Schichten des Stapels. Bevorzugt wird ein Verhältnisbereich der Spaltweiten des inneren Umfangsspaltes zum äußeren Umfangsspalt von 2 bis 5. Die Größe der Spaltweite des radial äußeren Umfangsspaltes wird derart klein ausgewählt, dass die Abzweigströmungen durch die Querspalte über die gesamte Stapelhöhe hin zustande kommen, ohne dass der Gasstrom ohne wesentliche Verzweigungen an den Querspalten insbesondere im oberen Stapelbereich vorbeiströmt. Für einen bevorzugten Druckbereich von 100 bis 300 mbar innerhalb der erfindungsgemäßen Verfahrensbedingungen hat sich eine maximale Spaltweite des radial äußeren Umfangsspaltes im Bereich von 8 mm als vorteilhaft herausgestellt. Bei kleineren Drücken z. B. im Bereich von 75 mbar soll von einer Spaltweite ausgegangen werden, die größer als 8 mm ist.

Die Spaltweite der Querspalte zur Spaltweite des radial äußeren Umfangsspaltes ist, wie bereits beschrieben, abhängig von der gewünschten Zieldichte der Abscheidungen, jedoch auch abhängig vom Durchmesser der Schichten des Stapels. Als bevorzugter Bereich des Verhältnisses der Spaltweite jedes der Querspalte (C) zu der Spaltweite des radial äußeren Umfangsspaltes (A) wird ein Bereich von wenigstens und vorzugsweise 0,5 bis 5 angesehen.

Das Gas aus dem radial inneren Umfangsspalt (B) kann durch den austrittsseitigen Endspalt am austrittsseitigen Ende des radial äußeren Umfangsspaltes aus der Reaktionszone herausfließen. Der querverlaufende austrittsseitige Endspalt könnte entlang wenigstens eines Teilabschnitts seiner radialen Ausdehnung auch unmittelbar zur Austrittsseite der Reaktionszone hin offen sein. Bevorzugt jedoch wird der austrittsseitige Endspalt in seiner Längsrichtung zur Austrittsseite der Reaktionszone hin insbesondere von der Basis eines Austritts-Leitkegels geschlossen, so dass auch die Außenseite der austrittsseitigen Endschicht des Stapels hauptsächlich von dem Gas aus dem radial inneren Umfangsspalt beströmt wird, ohne dass es zu einer Gashasennukleation am austrittsseitigen Ende des radial inneren Umfangsspalte kommt. Bevorzugt wird die Spaltweite des austrittsseitigen Endspaltes größer, vorteilhaft zu 1,5 bis 2, 5 mal größer, als die Spaltweite der Querspalte gewählt.

Vorzugsweise wird das Reaktionsgas dem radial äußeren Umfangsspalt durch einen Eintritts-Ringspalt mit bevorzugt konstanter Spaltweite mit einem Durchmesser zugeführt, welcher von einem zentralen Gaseinlass zu dem radial äußeren Umfangsspalt hin größer wird. Hierzu kann zwischen dem zentralen Einlass in den Reaktor und der eintrittsseitigen axialen Stirnseite des Probenkörper-Stapels ein Leitkegel vorgesehen sein, dessen Durchmesser in Axialrichtung des Stapels zu dem den Stapel aufnehmenden Reaktionsraum hin größer wird und von dem Eintritts-Ringspalt mit einer Spaltweite, die bevorzugt höchstens der Spaltweite des radial äußeren Umfangsspaltes entspricht, zwischen dem Mantel des Leitkegels und einem entsprechend hohlkegelförmigen Abschnitt der Reaktorwand umgeben ist. Der radial innere Umfangsspalt kann von der Grundfläche des Leitkegels geschlossen werden, wie auch der eintrittsseitige Endspalt, dessen Spaltweite vorzugsweise der Spaltweite der Querspalte entspricht, von dieser Grundfläche begrenzt sein kann. Das in den radial äußeren Umfangsspalt strömende Gas wird bevorzugt vor und/oder in dem Eintritts-Ringspalt, und zwar durch ein Beheizen des Eintritts-Leitkegels vorgewärmt.

An der anderen axialen Stirnseite des Stapels ist vorzugsweise ein Austritts-Ringspalt insbesondere innerhalb eines strömungsleitenden hohlkegelförmigen Abschnitts der Reaktorwand freigehalten, dessen Durchmesser von dem radial äußeren Umfangsspalt zu einem zentralen Auslass hin kleiner wird und in welchen der radial äußere Ringspalt einmünden. Der Austritts-Ringspalt hat bevorzugt ebenfalls eine Spaltweite, die der Spaltweite des radial äußeren Umfangsspaltes entspricht, jedoch auch größer sein kann als die Spaltweite des Umfangsspaltes. Der Austritts-Ringspalt kann an seiner radial inneren Seite ebenfalls von einem Leitkegel begrenzt sein, von dessen Grundfläche der radial innere Umfangsspalt geschlossen und der austrittsseitige Endspalt an seiner dem Stapel abgewendeten Seite begrenzt wird.

Das erfindungsgemäße Verfahren kann mit Vorteil auf die Gasphaseninfiltration beispielsweise von kohlenstoffhaltigen, gasförmigen Edukten und anderen refraktären Verbindungen wie SiC, BN, TiN, TiC angewendet werden.

Das erfindungsgemäß Verfahren wird bevorzugt auf eine Gasinfiltration von Kohlenstoff in poröse Probenkörper, beispielsweise sog. Faser- oder Sintermaterial durch Umsetzung von Methan (CH₄) angewendet. Bevorzugt wird hierbei das Methan in einem Temperaturbereich von 900 °C bis 1200 °C bei einem Druck von 50 bis 300 mbar und mit einer Verweilzeit in der Reaktionszone pro Durchlauf von 0,01 bis 1 s zu 10% bis 30%, vorzugsweise 20% umgesetzt. Da somit das Methan im Überschuß zugeführt wird, wird bei jedem Durchlauf durch die Reaktionszone ein typisches Abgas gebildet und abgeführt, welches eine Zusammensetzung von 55 - 755% Methan (CH₄) und 24 - 44% Wasserstoff (H₂) aufweist.

In einer vorteilhaften Ausgestaltung der Erfindung wird ein derartiges Abgas in einem Kreislaufverfahren beispielsweise in einer Methanisierungsanlage wiederaufbereitet, in welcher der Wasserstoff-Anteil mit Kohlendioxid (CO₂) und/oder Kohlenmonoxid (CO) wieder zu Methan aufbereitet wird, welches zusammen mit dem abgeführten Methan und frischen Methan in die Eintrittsseite der Reaktionszone für einen neuen Infiltrations-Durchlauf zurückgeführt wird.

Das Kohlendioxid und das Kohlenmonoxid können insbesondere auch aus anderen Abgasquellen stammen, so dass sie in der erfindungsgemäßen Weise zur Wiederaufbereitung des Abgases der Infiltrationsanlage wiederverwertet werden können. Hierzu lässt sich in der Methanisierungsanlage insbesondere auch Wasserstoff, bevorzugt auch Wasser, im Überschuss verwenden.

Daher wird das erfindungsgemäße Verfahren zur Abscheidung von Kohlenstoff bevorzugt mit einem in die Reaktionszone zugeführten Gas durchgeführt, das größer oder gleich 94% Methan und bis zu 6% Wasserstoff enthält.

Durch die erfindungsgemäße Wiederaufbereitung des Abgases aus dem Reaktor lässt sich der Frischgasbedarf, mit anderen Worten der Bedarf an Methan, welches beispielsweise aus einen Flüssiggastank (LNG Tank) zugeführt wird, auf bis zu 20% reduzieren. Hierdurch wird der Bedarf an frischem Methan reduziert. Zudem ermöglich das erfindungsgemäße Verfahren beispielsweise die umweltfreundliche Verarbeitung von Kohlendioxid (CO₂).

Entsprechend kann das erfindungsgemäße Verfahren auch bei anderen Precursoren als Methan zur Abscheidung von anderen refraktionären Stoffen als Kohlenstoff als Kreislaufverfahren gestaltet werden, indem das bei der Umsetzung des Precursors freiwerdende Nebenprodukt gemeinsam mit dem überschüssigen Precursor wieder aufbereitet wird und in den Einlass des Reaktors wieder zurückgeführt wird.

Weitere Vorteile, Merkmale und Einzelheiten der Erfindung ergeben sich aus den nachfolgenden Beschreibungen von bevorzugten Ausführungsbeispielen der Erfindung sowie anhand der Figuren der Zeichnung, die als Bestandteil der Beschreibung aufgefasst werden sollen.

Es zeigen
- Figur 1: eine Schemazeichnung eines Längsschnitts durch einen Reaktor zur Durchführung eines erfindungsgemäßen Verfahrens gemäß einem ersten Ausführungsbeispiel;
- Figur 2: eine Schemazeichnung eines Stapelaufbaus sowie von erfindungsgemäßen Spaltverhältnissen, und
- Figur 3: eine Prinzipdarstellung eines erfindungsgemäßen Verfahrens gemäß einem weiteren Ausführungsbeispiel, wobei ein Abgas vorzugsweise mittels einer Methanisierungsanlage aufbereitet wird.

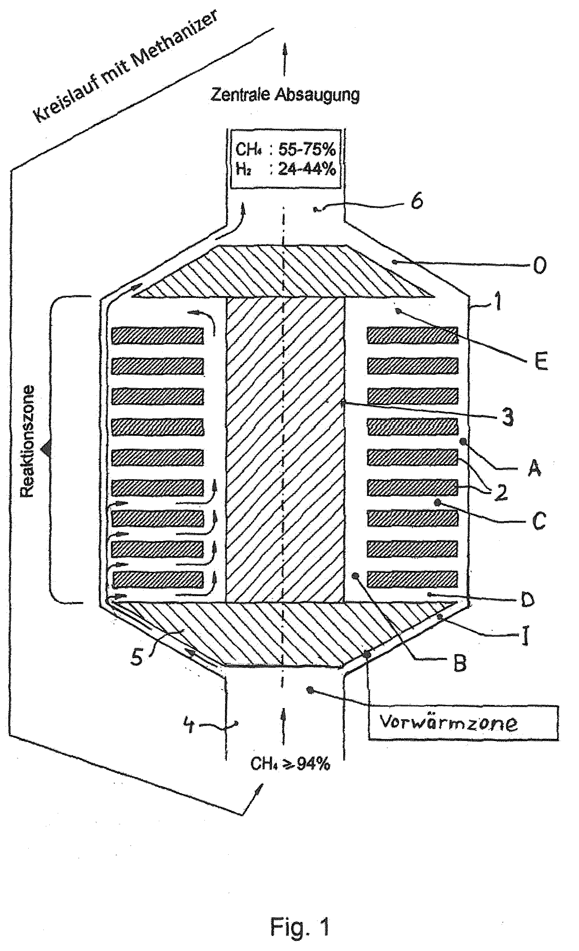

Fig. 1 zeigt eine Schemazeichnung eines Längsschnitts durch einen Reaktor zur Durchführung des erfindungsgemäßen Verfahrens. In einem Reaktorbehälter mit einer Behälterwand 1 sind in einer Reaktionszone eine Mehrzahl von ringförmigen Schichten 2 von Probenkörpern in einem vertikalen Stapel axial und konzentrisch im Abstand übereinander angeordnet und radial zum Stapel von vertikalen und im Querschnitt ringförmigen Umfangsspalten (A, B) aus einem radial äußeren Umfangsspalt (A) und einem radial inneren Umfangsspalt (B) konzentrisch umgrenzt. Jeder Umfangsspalt (A, B) hat in Umfangsrichtung des Stapels und in Vertikalrichtung eine konstante Spaltweite. Der radial äußere Umfangsspalt (A) ist entlang seines radial äußeren Umfangs von der Behälterwand (1) umgrenzt und ist an seinen Längsenden zu der Eintrittsseite und zu der Austrittsseite der Reaktionszone hin offen. Im zentralen Innenraum des Stapels aus ringförmigen Schichten (2) ist ein Kern (3) angeordnet, von welchem der radial innere Umfangsspalt (B) entlang seines radial inneren Umfangs umgrenzt wird. Der radial innere Umfangsspalt (B) ist an seinen Längsenden zur Eintrittsseite und zur Austrittsseite der Reaktionszone hin geschlossen. Von den Abständen zwischen jeweils aufeinander folgenden Schichten werden quer, gemäß Figur 1 senkrecht zu den Umfangsspalten (A, B) verlaufende Querspalte C mit in Radialrichtung des Stapels konstanter und untereinander gleichen Spaltweiten ausgebildet, die in die Umfangsspalte (A, B) offen einmünden. Der Innenraum des Reaktors wie auch der Stapel aus ringförmigen Schichten sind vorzugsweise zylindrisch ausgestaltet.

Der Innenraum des Reaktorbehälters (1) wird axial - in Vertikalrichtung - von dem Reaktionsgas durchströmt, das zentral in den Reaktorbehälter eingeführt und zentral aus dem Reaktorbehälter abgeführt wird.

Zwischen einem zentralen Einlass (4) und der einen, in Fig. 1 unteren axialen Stirnseite des Probenkörper-Stapels ist ein bevorzugt kegelstumpfförmiger Eintritts-Leitkegel (5) vorgesehen, dessen Durchmesser axial zu dem den Stapel aufnehmenden Reaktionsraum im Innenraum des Reaktors hin größer wird und von einem Eintritts-Ringspalt (I) zwischen der Mantelfläche des Leitkegels und einem entsprechend hohlkegelförmigen Abschnitt der Reaktorwand (1) umgeben ist, so dass der Eintrittsstrom in den radial äußeren Umfangsspalt (A) geleitet wird. Bevorzugt hat der Eintritts-Ringspalt wenigsten an seiner Mündung in den Außenspalt eine Spaltweite, die derjenigen des radial äußeren Umfangsspaltes (A) entspricht.

Von der Basisfläche des Leitkegels (5) wird der radial innere Umfangsspalt (B) an der Eintrittsseite des Reaktionsraums axial geschlossen, wobei jedoch zwischen der dem Einlauf nächst benachbarten Schicht (2) und der Basis des Leitkegels (5) ein den Querspalten (C) in deren Spaltweite entsprechender eintrittsseitiger querverlaufender Endspalt (D) verbleibt.

Zwischen der anderen, in Fig. 1 oberen axialen Stirnseite des Stapels und einem zentralen Gasauslass (6) ist innerhalb eines strömungsleitenden hohlkegelförmigen Abschnitts der Reaktorwand 1 vorzugsweise ein Austritts-Leitkegel (7) vorgesehen, der bevorzugt ebenfalls kegelstumpfförmig ist und dessen Durchmesser axial zu dem Gasauslass (6) hin kleiner wird und von einem Austritts-Ringspalt (O) zwischen der kegeligen Außenfläche des Leitkegels (7) und dem hohlkegelförmigen Abschnitt der Reaktorwand umgrenzt ist. Die Spaltweite des Austrittsringspaltes (O) kann ebenfalls der Spaltweite des radial äußeren Umfangsspaltes (A) entsprechen, ist jedoch vorzugsweise etwas größer als die Spaltweite des radial äußeren Umfangsspaltes (A).

Von der Basisfläche des Austritts-Leitkegels (7) , oder bei dessen Fehlen von einer eingebauten Querplatte oder dergleichen, wird der radial innere Umfangsspalt (B) an der Austrittsseite des Reaktionsraums in seiner vertikalen Längsrichtung geschlossen, wobei jedoch zwischen der der Austrittsseite der Reaktionszone nächst-benachbarten Schicht (2) des Stapels und der Basis des Leitkegels (7) ein querverlaufender austrittsseitiger Endspalt (E) verbleibt. Dieser querverlaufende Endspalt (E) entspricht den Querspalten (C), wobei jedoch seine Spaltweite größer als die Spaltweite der Querspalte (C) ist. Vorzugsweise entspricht die Spaltweite des Austritts-Ringspaltes (O) der Spaltweite des austrittsseitigen Endspaltes (E).

Das Verhältnis der Spaltweiten des radial inneren Umfangsspaltes (B) zum radial äußeren Umfangsspalt (A) ist erfindungsgemäß größer 1 und kleiner gleich 20. Das Verhältnis der Spaltweiten jedes Querspaltes (C) zum radial äußeren Umfangsspalt (A) liegt erfindungsgemäß im Bereich von 0,25 bis 12. Die vorgenannten Spaltweitenverhältnisse (B) zu (A) und (C) zu (A) werden bevorzugt derart ausgewählt, dass das Verhältnis der Spaltweite des radial inneren Querspaltes (B) zu der Spaltweite jedes der Querspalte (C) größer 1 und kleiner gleich 10, bevorzugt größer 1 und kleiner gleich 5 ist. Innerhalb dieser Bereiche können die Spaltweiten variiert werden, wobei bevorzugt ein Gesamtverhältnisbereich A:B:C von 1:2:0,5 bis 1:10:5 angewendet wird. Das Verhältnis der Spaltweite des austrittsseitigen Endspaltes (E) zu der Spaltweite der Querspalte (C) liegt vorzugsweise im Bereich von 1,5 bis 2,5.

Die zwischen den Leitkegeln ausgebildete Reaktionszone wird im Betrieb des Reaktors auf die Reaktionstemperatur beheizt. Außerdem wird der eintrittsseitige Leitkegel (5) beheizt, so dass das durch den Gaseinlass 4 eintretende Gas in dem Eintritts-Ringspalt entlang einer verhältnismäßig großen Heizfläche entlang des Eintritts-Leitkegels (5) vorgewärmt wird, ohne jedoch die Aktivierungstemperatur des hindurchströmenden Precursorgases zu erreichen.

Der in Fig. 1 schematisch dargestellte Reaktor wird - wie bevorzugt - von unten nach oben durchströmt. Es ist jedoch auch möglich, den Reaktor für eine umgekehrte Durchströmung von oben nach unten einzurichten. In diesem Fall ist der Reaktor im Vergleich mit der Darstellung in Fig. 1 um 180 Grad gedreht angeordnet, so dass der Gaseinlass 4 oben, und der Gasauslass 6 unten angeordnet sind.

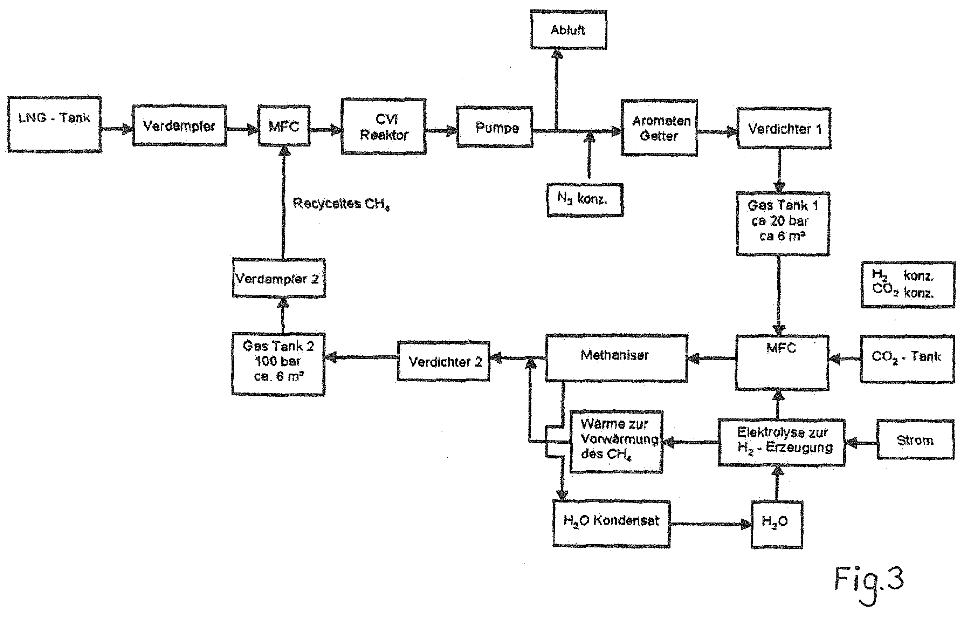

Weiterhin kann für Abscheidung von Kohlenstoff, wie in Fig. 1 schematisch gezeigt, das erfindungsgemäße Verfahren als Kreislaufverfahren bereitgestellt werden, bei welchem zusätzlich eine Methanisierungsanlage - auch Methanizer genannt - zur Regeneration des als Precursor eingesetzten Methans (CH4) aus dem Abgas des Reaktors zwischengeschaltet wird. Dies wird anhand von Fig. 3 noch erläutert.

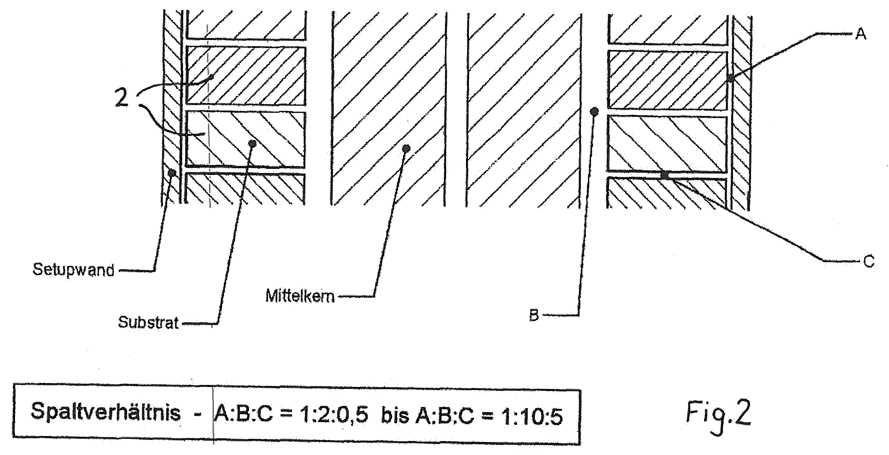

Fig. 2 zeigt in einem Querschnitts-Ausschnitt aus Fig. 1 eine als Setupwand bezeichnete Reaktorwand (1), in welche der Stapel aus den zu infiltrierenden porösen Strukturen eingesetzt werden, von denen die Schichten (2) des Stapels gebildet werden. Der den radial inneren ringförmigen Umfangsspalt (B) radial innen begrenzende Mittelkern (3) kann zusätzlich dazu dienen, die porösen Strukturen zu fixieren. Hierzu können vorzugsweise Graphitstifte am Mittelkern angeordnet werden, welche die poröse Struktur halten. Es können auch andere oder zusätzliche Haltezungen, beispielsweise aus anderem Material vorgesehen sein. Die entsprechende Halterung kann in Form, Material und Größe an den jeweiligen Probenkörper angepasst werden. Für die Prinzipdarstellung in Figur 2 wurde zur Vereinfachung auf die Wiedergabe dieser Stifte verzichtet. Die Probenkörper werden äquidistant übereinander gestapelt. Hierbei ist der Spaltabstand des Querspaltes (C) im vorliegenden Ausführungsbeispiel stets konstant. Zwischen Reaktorwand (1) und dem radial äußeren Rand der Schichten (2) ist ein radial äußerer Umfangsspalt (A) ausgebildet, welcher in seiner Spaltweite konstant ist. Zusätzlich gibt es noch den radial inneren Umfangsspalt (B) zwischen Mittelkern (2) und dem radial inneren Rand der Probenkörper. Die Spaltweite dieses radial inneren Umfangsspaltes (B) ist bezogen auf die jeweilige Größe der Probenkörper und ist für einen gegebenen Probenkörper konstant.

Die Spaltweite des radial äußeren Umfangsspaltes wird eng genug gewählt, dass die Querströungen des Gases in und durch die Querspalte über die Höhe des Stapels hin, insbesondere auch noch an den im oberen Bereich des Stapels zustande kommen, ohne dass die Hauptmenge des Gases an den radial äußeren Enden der Querspalte ohne Verzweigung in den Querspalten vorbeiströmt. Da die Spaltweite des radial inneren Umfangsspaltes (B) größer, vorzugsweise um 2 bis 5 mal größer, als die Spaltweite des radial äußeren Umfangsspaltes (A) ist, werden jedoch die Abzweigströmungen durch die Querspalte zusätzlich angetrieben. Für einen Druckbereich von 100 bis 300 mbar hat sich eine maximale Spaltweite des radial äußeren Umfangsspalte von 8 mm im gängigen Durchmesserbereich von Bremsscheiben und dergleichen Probenkörper als vorteilhaft erwiesen, wobei eine demgegenüber größere Spaltweite des Umfangsspaltes (A) bei geringeren Drücken vorteilhaft ist.

Die Spaltweite der Querspalte (C) wird bestimmt in Abhängigkeit von der Größe des jeweiligen Probenkörpers und/oder der angestrebten Homogenität und/oder einer gewünschten Zieldichte des jeweiligen refraktären Stoffes.

Beispielsweise kann der Querspalt (C) nach dem Verhältnis von radialer Länge zu Dicke des Probenkörpers bestimmt werden. In diesem Fall ist beispielsweise zum Erreichen einer bestimmten Zieldichte der Querspalt (C) mit einer größeren Spaltweite zu wählen, wenn das Verhältnis von radialer Länge zu Dicke des Probenkörpers groß ist, und umgekehrt mit einer kleineren Spaltweite zu wählen, wenn das Verhältnis von radialer Länge und Dicke klein ist.

Fig. 3 zeigt eine Prinzipdarstellung eines erfindungsgemäßen Verfahrens gemäß einem weiteren Ausführungsbeispiel, wobei im Falle einer Abscheidung von Kohlenstoff das Abgas aus der Reaktionszone des Reaktors in und mittels einer Methanisierungsanlage aufbereitet wird. Der Aufbau der Anlage ist durch die in Fig. 3 angegeben Beschreibung der Komponenten wie auch durch die eingezeichneten Pfeile ersichtlich. Aus einem Flüssiggastank (oder auch LNG Tank) wird Methan für die Reaktion im erfindungsgemäßen CVI-Reaktor entnommen.

Das verfahrensgemäße Abgas besteht beispielsweise aus:
- ca. 63% unverbrauchtem Methan;
- ca. 32% Wasserstoff;
- der Rest ist Wasser und enthält eventuell andere Kohlenwasserstoffe.

Der Wasserstoffgehalt des Abgases wird zunächst gemessen. Entsprechend wird Kohlendioxid (CO₂) und/oder Kohlenmonoxid (CO) zugemischt, um in der Methanisierungsanlage aus dem im Abgas befindlichen Wasserstoff, der als Nebenprodukt bei der Umsetzung des Methans in den dem Reaktor freigesetzt wird, erneuertes Methan zu bilden. So können beispielsweise ca. 10% oder mehr zurückgewonnenes Methan zusammen mit dem nicht-umgesetzten Methan in das Kreislaufverfahren zurückgeführt werden. Die weiteren zwischen 25% und 30% Methan werden aus dem Flüssiggastank nachgespeist.

Vorteilhaft kann somit, um von externen Methanlieferungen weitgehend unabhängig zu sein, zusätzlich Kohlenmonoxid CO oder Kohlendioxid C0₂ zugeführt werden. Hierdurch wird der Anteil an zu Methan umgesetztem Wasserstoff (H₂) des Abgases bereits deutlich erhöht. Besonders vorteilhaft kann zudem zusätzlicher Wasserstoff (H₂) zugeführt werden, so dass die Umsetzung von im Abgas enthaltenem Wasserstoff (H₂) und beispielsweise zugeführtem Kohlendioxid (CO₂) oder Kohlenmonoxid (CO) zusätzlich optimiert wird und hierdurch die dem Kreislaufprozess zulieferbare Ausbeute an Methan (CH₄) als gasförmigem Precursor zusätzlich optimiert wird.

Der zusätzliche Wasserstoff kann beispielsweise mittels Elektrolyse aus Wasser (H₂0) gewonnen werden. Im Abgas enthaltender Wasserdampf säubert vorteilhaft den Katalysator der Methanisierungsanlage. Bezüglich der verwendbaren Katalysatoren sind eine Vielzahl verschiedener Katalysatoren verwendbar beispielsweise nickelbasierte Katalysatoren aber auch zum Beispiel Edelmetalle wie Pt, Pd verwendbar.

### Ausführungsbeispiel 2:

Am Beispiel der Kohlenstoffabscheidung wird das erfindungsgemäße Verfahren exemplarisch beschrieben wobei, hinsichtlich der Einzelheiten der Abscheidungsreaktion von Kohlenstoff aus Methan als gasförmigem Precursor sowie beispielhafte Reaktionsparameter auf die EP 0 946 459 B1 verwiesen wird.

Die porösen Strukturen oder auch Probenkörper werden in einer Reaktionszone mit einem wenigstens einen gasförmigen Precursor enthaltenden Gas vorzugsweise allseitig beströmt. Hierbei weisen Umfangsspalte (A) bzw. (B) sowie Querspalte (C) welche an und um den Probenkörper angeordnet sind jeweils die weiter oben diskutierten Spaltweitenverhältnisse auf.

Das wenigstens einen gasförmigen Precursor, hier Methan (CH₄) als im Wesentlichen einzigen Precursor, enthaltende Gas, beispielsweise Erdgas, wird in einer Vorwärmzone, beispielsweise dem in Fig. 1 dargestellten Eintrittsringspalt I entlang des Eintritts-Leitkegels (5), des Reaktors vorgewärmt und damit thermisch angeregt.

Die Vorwärmung erfolgt jedoch nur soweit, dass noch kein Zerfall des Methans und somit Radiakalbildung eintritt. Das aktivierte Gas durchströmt anschließend die Spalte um die Probenkörper.

Vorzugsweise kann die chemische Gasphaseninfiltration von Kohlenstoff (C) mit technisch reinem Methan durchgeführt werden. Reaktionstemperatur, Reaktionsdruck und Strömungsgeschwindigkeit werden in der Weise eingestellt, dass vor Abreaktion des gasförmigen Precursors Methan (CH₄) zunächst eine Diffusion des Methans (CH₄) in die Poren der Probenkörper stattfindet. Erst in den Poren der Probenkörper kommt es zur vermehrten Radikalbildung und damit Abscheidung des hieraus resultierenden Kohlenstoffes in den Poren der porösen Probenkörper. Bei der Reaktion wird Wasserstoff (H₂) gebildet, welcher durch Rückdiffusion wieder aus dem Probenkörper entweicht. Durch diesen Vorgang wird das Konzentrationsgefälle zwischen der Oberfläche des Probenkörpers und dessen Inneren erhöht, was zu einer beschleunigten Diffusion weiteren Methans in den Probenkörper führt.

Fig. 1 und 2 zeigen, dass die Probenkörper von verschiedenen Spalten umgeben sind. Diese Spalte sind nicht stets gleich, sondern der jeweiligen Verweilzeit des Gases am Reaktionsort angepasst. Hierbei sind die Gasverweilzeiten in den Umfangsspalten (A) und (B) nahezu gleich. Die Gasverweilzeit im Querspalt (C) wird derart eingestellt, dass eine möglichst homogene Verdichtung der Probenkörper gewährleistet ist. Die Anordnung der Spalte zu den Probenkörpern ist mit anderen Worten sowohl parallel (Spalte (A) und (B)) als auch quer (Spalt (C)) zur Hauptströmungsrichtung durch den Reaktor.

Die Gasführung im Reaktor ist dergestalt, dass das den gasförmigen Precursor enthaltende Gas in die Vorwärmzone am Gaseinlass (4) und in dem Eintrittsringspalt (I) des Reaktors strömt. Von dort fließt das Gas entlang des Außenumfangs des Probenkörperstapels (Umfangsspalt (A)), wird von dortin die Querspalte (C) abgezweigt und verteilt und fließt zum inneren Umfangsspalt (B) . Aus dem radial innere Umfangsspalt kann das Gas durch den austrittsseitigen Endspalt (E), der am austrittsseitigen Ende des radial äußeren Umfangsspaltes in diesen mündet in den Austritts-Ringspalt O abfließen. Die Durchströmung des Reaktors mit dem Gas kann von unten nach oben oder von oben nach unten erfolgen. Im letzter Fall wird der Reaktor aus Fig. 1 um 180° gedreht, so dass Gaseinlass 4 und Gasauslass 6 miteinander vertauscht werden.

Durch eine entsprechende Anpassung der Spaltweite der Querspalte (C) wird ermöglicht, eine gewünschte Zieldichte für die eingesetzten Probenkörper zu erreichen. Beispielsweise konnten bei einer erfindungsgemäßen Gashasen-Infiltration von Kohlenstoff in eine ringförmigen Scheibe mit einem Außendurchmesser von 390 mm und einem Innendurchmesser von 158 mm bei einem gleichbleibemnden Verhältnis der Spaltweite des radial inneren Umfangsspaltes (B) zu der Spaltweite des radial äußeren Umfangsspaltes (A) folgende Zieldichten durch Änderung des Verhältnisses (B:C) der Spaltweite des radial inneren Umfangsspaltes (B) zu der Spaltweite jedes der Querspalte (C) erhalten werden:

| **Zieldichte** | **Spaltverhältnis (B):(C)** |
|---|---|
| > 1,6 g/ccm | 3,5 bis 4 |
| 1,3 g/ccm | 2,4 bis 2,8 |
| 1,0 g/ccm | 1,7 bis 2,0 |
| < 1,0 g/ccm | 1,2 bis 1,5 |

Der bei der Reaktion gebildete Wasserstoff (H₂) führt lokal zwar zu einer Verdünnung der Methankonzentration, jedoch wird dieser durch die gezielte Absaugung schnell vom Reaktionsort abgeführt. Da außerdem das im System vorhandene Methan im deutlichen Überschuss vorlegt, bleibt dieser und damit die Sättigungsadsorptionsbedingung trotz der Wasserstoffmengen erhalten.

Hauptbestandteile des verfahrensgemäßen Abgases sind im Ausführungsbeispiel Methan zu ca. 63% und Wasserstoff zu ca. 32%.

Das Abgas kann vorzugsweise mittels eines Blockheizkraftwerkes verstromt werden.

Alternativ kann der im Abgas enthaltene Wasserstoff (H₂), wie aus Fig. 3 schematisch ersichtlich, besonders vorteilhaft mittels einer Methanisierungsanlage in weiter oben bereits erläuterter Weise wieder für ein CVI-Verfahren verwertbar gemacht werden, indem der Wasserstoff (H2) durch Reaktion beispielsweise mit Kohlendioxid (C0₂) und / oder auch Kohlenmonoxid (CO) wieder zu Methan (CH₄) umgesetzt wird. Zur weiteren Optimierung ist es auch erfindungsgemäß möglich, zusätzlich Wasserstoff wie auch Wasser zuzuführen, um das beispielsweise zugeführte Kohlendioxid (C0₂) und/ oder auch das beispielsweise zugeführte Kohlenmonoxid (CO) optimiert umzusetzen und beispielsweise bei der Reaktion des Wasserstoffs (H₂) des Abgases mit dem zugeführten Kohlendioxid zu Methan auftretende Verluste durch als Nebenprodukt entstehendes Wasser (H₂0) zusätzlich auszugleichen. Das erfindungsgemäße Verfahren kann daher besonders vorteilhaft als Kreislaufverfahren betrieben werden. In diesem Fall wird das aus dem Wasserstoff (H₂) des Abgases gewonnene Methan (CH₄) wieder als gasförmiger Precursor dem erfindungsgemäßen Verfahren zugeführt.

Die Durchführung des erfindungsgemäßen Verfahrens als Kreislaufverfahren unter Nutzung einer Methanisierungsanlage ist beispielsweise schematisch in Fig. 3 dargestellt.

Fig. 3 zeigt schematisch die Aufbereitung des verfahrensgemäßen Abgases der Zusammensetzung ca. 63% Methan (CH₄) und ca. 34% Wasserstoff (H₂) mittels einer Methanisierungsanlage. Die Umsetzung ergab ein Gasgemisch von ca. 95% Methan (CH₄) und ca. 4% Wasserstoff (H₂). Diese Gasmischung enthält ausreichend Methan (CH₄) als gasförmigen Precursor und kann daher dem erfindungsgemäßen Verfahren wieder als gasförmigen Precursor enthaltendes Gas zugeführt werden. Der geringe Wasserstoffanteil (H₂) beeinflusst die erfindungsgemäße chemische Gasphaseninfiltration von Kohlenstoff nicht merklich. Bei dieser Form der Rückgewinnung muss nur jeweils maximal 30% "frisches Erdgas" (Methan) zugegeben werden, und ist somit besonders vorteilhaft, da es eine große Ersparnis an gasförmigen Precursor enthaltendem Frischgas - beispielsweise Erdgas - ermöglicht. Somit wird besonders vorteilhaft der im verfahrensgemäßen Abgas enthaltene Wasserstoff recycled unter Verwendung von beispielsweise Kohlendioxid (C0₂) und/oder Kohlenmonoxid (CO). Beispielsweise im Rahmen von Verbrennungsprozessen angefallenes C0₂ kann so umweltfreundlich verbraucht werden.

Der zusätzlich zugeführte Wasserstoff (H₂) beispielsweise in einem Volumenverhältnis von Methan bzw. Erdgas und beigemischtem Wasserstoff (H₂) 20:1 bis 2:1, vorzugsweise 10:1 bis 5:1, kann vorteilhaft mittels Elektrolyse - beispielsweise aus Wasser (H₂0) - gewonnen werden.

Der Temperaturbereich für die Gasphaseninfiltration liegt für Kohlenstoff vorzugsweise in einem Temperaturbereich von 1000°C bis 1200°C.

## Patentansprüche

1. Verfahren zur chemischen Gasphaseninfiltration von wenigstens einem refraktären Stoff, bei welchem Verfahren in einer Reaktionszone eine poröse Struktur mit einem wenigstens einen gasförmigen Precursor enthaltenden Gas beströmt wird, wobei bei gegebener Temperatur in der Reaktionszone der Partialdruck des wenigstens einen gasförmigen Precursors und die Verweilzeit des Gases in der Reaktionszone derart eingestellt werden,
dass in der porösen Struktur eine Abscheidungsreaktion des Precursors im Partialdruckbereich der Sättigungsadsorption erfolgt, wobei Sättigungsadsorption bedeutet, dass bei einer Erhöhung des Partialdruckes des gasförmigen Precursors die Abscheidungsgeschwindigkeit im Wesentlichen konstant bleibt bzw. unwesentlich erhöht wird, und
die Umsetzung des wenigstens einen gasförmigen Precursors in jedem Stadium der Infiltration so begrenzt wird, dass beim Durchströmen der Reaktionszone nicht mehr als 50%, vorzugsweise 10% bis 25%, des im Gas zugeführten, eine feste Phase bildenden, wenigstens einen gasförmigen Precursors als feste Phase in der porösen Struktur abgeschieden werden, und
die Beströmung der porösen Struktur in mindestens einem in Vertikalrichtung zwischen einer Eintrittsseite und einer Austrittsseite der Reaktionszone angeordneten vertikalen Stapel aus übereinander liegenden ringförmigen Schichten durch vertikale Umfangsspalte (A, B) aus wenigstens einem ringförmigen radial äußeren Umfangsspalt (A) und wenigstens einem ringförmigen radial inneren Umfangsspalt (B) wie auch durch zwischen den Schichten quer zur Vertikalrichtung verlaufende Querspalte (C) und querverlaufende Endspalte (D, E) zwischen der Eintrittseite und der Austrittsseite der Reaktionszone und der jeweils benachbarten Schicht des Stapels erfolgt, wobei die Querspalte und die Endspalte zu den Umfangsspalten (A, B) hin offen sind, und jeder der Umfangsspalte eine Spaltweite hat, die wenigstens in Umfangsrichtung des Stapels konstant ist, und der äußere Umfangsspalt zu der Eintrittsseite und zu der Austrittsseite der Reaktionszone hin offen ist und der innere Umfangsspalt zu der Eintrittsseite und zu der Austrittsseite hin geschlossen ist, wobei das Verhältnis der Spaltweite des radial inneren Umfangsspaltes (B) zu der Spaltweite des radial äußeren Umfangsspalts (A) größer 1 und kleiner gleich 20 ist und das Verhältnis der Spaltweite der Querspalte (C) zum radial äußeren Umfangsspalt 0,25 bis 12 beträgt.

2. Verfahren nach Anspruch 1, wobei das Verhältnis der Spaltweite des radial inneren Umfangsspaltes (B) zu der Spaltweite des radial äußeren Umfangsspalts (A) 2 bis 10 beträgt.

3. Verfahren nach Anspruch 1 oder 2, wobei das Verhältnis der Spaltweite der Querspalte (C) zu der Spaltweite des radial äußeren Umfangsspaltes (A) 0,5 bis 10, bevorzugt 0,5 bis 5 beträgt.

4. Verfahren nach einem der Ansprüche 1 bis 3, wobei das Verhältnis der Spaltweite des radial inneren Umfangsspaltes (B) zu der Spaltweite der Querspalte (C) im Bereich zwischen 1 und 5 liegt.

5. Verfahren nach einem der Ansprüche 1 bis 4, wobei ein Gesamtspaltweitenverhältnis (A:B:C) der Spaltweite des radial äußeren Umfangsspaltes (A) zu der Spaltweite des radial inneren Umfangsspaltes (B) zu der Spaltweite jedes der Querspalte (C) im Bereich von 1:2:05 bis 1:10:5 liegt.

6. Verfahren nach einem der Ansprüche 1 bis 5, wobei der austrittsseitige Endspalt (E) eine Spaltweite hat, die größer als die Spaltweite jedes der Querspalte (C) ist.

7. Verfahren nach Anspruch 6, wobei das Verhältnis der Spaltweite des austrittsseitigen Endspaltes (E) zu der Spaltweite jedes der Querspalte (C) 1,5 bis 2,5 beträgt.

8. Verfahren nach einem der Ansprüche 1 bis 7, wobei das Gas dem radial äußerem Umfangsspalt (A) durch einen Eintritts-Ringspalt (I) mit einem Durchmesser zugeführt wird, welcher von einem zentralen Gaseinlass zu dem radial äußeren Umfangsspalt (A) hin größer wird, und aus dem radial äußeren Ringspalt (A) durch einen Austritts- Ringspalt (0) mit einem Durchmesser abgeführt wird, welcher von dem radial äußeren Umfangsspalt (A) zu einem zentralen Auslass hin kleiner wird.

9. Verfahren nach Anspruch 8, wobei der wenigstens eine gasförmige Precursor in dem Eintritts-Ringspalt (F) vorerwärmt wird.

10. Verfahren nach einem der Ansprüche 1 bis 9, wobei die Beströmung der porösen Struktur in mehreren nebeneinander angeordneten gleichartigen Stapeln erfolgt, wobei jeder der Stapel mit einer Reaktorwand umgeben wird, von welcher wenigstens der ringförmige äußere Umfangsspalt (A) eines jeden der Stapel umgrenzt wird.

11. Verfahren nach einem der Ansprüche 1 bis 10, welches als Kreislaufverfahren durchgeführt wird, bei dem ein Abgas, welches zusammengesetzt ist aus dem bei der begrenzten Umsetzung des Precursorgases freigesetzten Nebenprodukt und dem nicht-umgesetzten Anteil des Precursogases, aus der Reaktionszone in eine Aufbereitungsanlage abgezogen wird, in welcher das Nebenprodukt wieder zu erneuertem Precursorgas aufbereitet wird, und das derart wieder aufbereitete Abgas in die Reaktionszone zurückgeführt wird.

12. Verfahren nach einem der Ansprüche 1 bis 11, welches zur Gasinfiltration von Kohlenstoff (C) durch Umsetzung von Methan (CH₄) in einem Temperaturbereich von 900 °C bis 1200 °C bei einem Druck von 50 bis 300 mbar verwendet wird, wobei die Verweilzeit des Gases in der Reaktionszone 0,01 bis 1 Sekunde beträgt.

13. Verfahren nach Anspruch 12, wobei aus der Reaktionszone ein Abgas abgeführt wird, welches überwiegend Methan sowie Wasserstoff enthält, und in eine Methanisierungsanlage geleitet wird, in welcher der Wasserstoff (H2) zu Methan (CH4) aufbereitet wird und zusammen mit dem abgeführten Methan und mit frischem Methan in die Reaktionszone zurückgeführt wird.

14. Verfahren nach Anspruch 13, wobei aus der Reaktionszone ein aus Methan (CH4) und Wasserstoff (H2) zusammengesetztes Abgas abgeführt wird, das 55% bis 75% Methan (CH4) und 24% bis 44% Wasserstoff (H2) enthält, und/oder wobei die Aufbereitung des Wasserstoffs durch dessen Umsetzung mit Kohlendioxid (CO₂) und/oder Kohlenmonoxid (CO) erfolgt, und/oder wobei dem Abgas in der Methanisierungsanlage zusätzlich Wasserstoff (H₂) und Wasser (H2O) zugeführt wird.

15. Verfahren nach einem der Ansprüche 13 und 14, wobei das in die Reaktionszone zurückgeführte Gas mindestens 94% Methan (CH₄) und bis zu 6% Wasserstoff (H₂) enthält.

## Claims

1. Method for chemical vapor infiltration of at least one refractory substance, in which method a porous structure is subjected in a reaction zone to the flow of a gas containing at least one gaseous precursor, wherein, at a given temperature in the reaction zone, the partial pressure of the at least one gaseous precursor and the dwell time of the gas in the reaction zone are set in such a manner, that
in the porous structure, a deposition reaction of the precursor occurs in the partial pressure range of the saturation adsorption, wherein saturation adsorption means that the deposition speed substantially remains constant or is increased insignificantly when the partial pressure of the gaseous precursor is increased, and
the reaction of the at least one gaseous precursor is limited in each stage of the infiltration in such a manner that, when flowing through the reaction zone, no more than 50%, preferably 10% to 25%, of the at least one gaseous precursor forming a solid phase and supplied in the gas are deposited as a solid phase in the porous structure, and
the exposure of the porous structure to the flow occurs in at least one vertical stack of superimposed ring-shaped layers, the stack being arranged in a vertical direction between an inlet side and an outlet side of the reaction zone, through vertical circumferential gaps (A, B) of at least one ring-shaped radially outer circumferential gap (A) and at least on ring-shaped radially inner circumferential gap (B) as well as through transverse gaps (C) extending between the layers transverse to the vertical direction and transverse end gaps (D, E) between the inlet side and the outlet side of the reaction zone and the respective neighboring layer of the stack, wherein the transverse gaps and the end gaps are open towards the circumferential gaps (A, B), and each of the circumferential gaps has a gap width that is constant at least in a circumferential direction of the stack, and the outer circumferential gap is open towards the inlet side and towards the outlet side of the reaction zone, and the inner circumferential gap is closed towards the inlet side and towards the outlet side, wherein the ratio of the gap width of the radially inner circumferential gap (B) to the gap width of the radially outer circumferential gap (A) is greater than 1 and equal or less than 20 and the ratio of the gap width of the transverse gaps (C) to the radially outer circumferential gap is 0.25 to 12.

2. Method according to claim 1, wherein the ratio of the gap width of the radially inner circumferential gap (B) to the gap width of the radially outer circumferential gap (A) is 2 to 10.

3. Method according to claim 1 or 2, wherein the ratio of the gap width of the transverse gaps (C) to the gap width of the radially outer circumferential gap (A) is 0.5 to 10, preferably 0.5 to 5.

4. Method according to any one of claims 1 to 3, wherein the ratio of the gap width of the radially inner circumferential gap (B) to the gap width of the transverse gaps (C) is in the range between 1 and 5.

5. Method according to any one of claims 1 to 4, wherein a total gap width ratio (A:B:C) of the gap width of the radially outer circumferential gap (A) to the gap width of the radially inner circumferential gap (B) to the gap width of each of the transverse gaps (C) is in the range of 1:2:0.5 to 1:10:5.

6. Method according to any one of claims 1 to 5, wherein the outlet side end gap (E) has a gap width that is greater than the gap width of each of the transverse gaps (C).

7. Method according to claim 6, wherein the ratio of the gap width of the outlet side end gap (E) to the gap width of each of the transverse gaps (C) is 1.5 to 2.5.

8. Method according to any one of claims 1 to 7, wherein the gas is supplied to the radially outer circumferential gap (A) through an inlet ring gap (I) having a diameter that increases from a central gas inlet towards the radially outer circumferential gap (A), and is discharged from the radially outer ring gap (A) through an outlet ring gap (O) having a diameter that decreases from the radially outer circumferential gap (A) towards a central outlet.

9. Method according to claim 8, wherein the at least one gaseous precursor is preheated in the inlet ring gap (F).

10. Method according to any one of claims 1 to 9, wherein the exposure of the porous structure to the gas flow occurs in several stacks of the same type arranged next to each other, wherein each of the stacks is surrounded by a reactor wall by which at least the ring-shaped outer circumferential gap (A) of each stack is defined.

11. Method according to any one of claims 1 to 10, which is carried out as a cycle process, wherein an exhaust gas composed of the byproduct released during the limited reaction of the precursor gas and the unreacted fraction of the precursor gas is drawn off from the reaction zone into a processing plant, in which the byproduct is reprocessed to regenerated precursor gas and the exhaust gas reprocessed in such a manner is returned into the reaction zone.

12. Method according to any one of claims 1 to 11, which is used for vapor infiltration of carbon (C) by reacting methane (CH₄) in a temperature range of 900°C to 1.200°C at a pressure of 50 mbar to 300 mbar, the dwell time of the gas in the reaction zone being 0.01 to 1 second.

13. Method according to claim 12, wherein an exhaust gas is discharged from the reaction zone which predominantly contains methane and hydrogen, and is led into a methanization plant in which the hydrogen (H₂) is processed to methane (CH₄), which is returned into the reaction zone together with methane discharged from the reaction zone and fresh methane.

14. Method according to claim 13, wherein an exhaust gas composed of methane (CH₄) and hydrogen (H₂) is discharged from the reaction zone, containing 55% to 75% methane (CH₄) and 24% to 44% hydrogen (H₂), and/or wherein the hydrogen is processed by its reaction with carbon dioxide (CO₂) and/or carbon monoxide (CO), and/or wherein hydrogen (H₂) and water (H₂O) are additionally supplied to the exhaust gas in the methanization plant.

15. Method according to any one of claims 13 and 14, wherein the gas returned into the reaction zone contains at least 94% methane (CH₄) and up to 6% hydrogen (H₂).

## Revendications

1. Procédé d'infiltration chimique en phase gazeuse d'au moins une substance réfractaire, procédé dans lequel, dans une zone de réaction, on envoie sur une structure poreuse un gaz contenant au moins un précurseur gazeux, la pression partielle du ou des précurseurs gazeux, et le temps de séjour du gaz dans la zone de réaction, étant, à une température donnée dans la zone de réaction, ajustés de telle sorte que
dans la structure poreuse, il se produise une réaction de dépôt du précurseur dans la zone à pression partielle de l'adsorption à saturation, l'adsorption à saturation signifiant que, pour une augmentation de la pression partielle du précurseur gazeux, la vitesse de dépôt reste pour l'essentiel constante ou augmente d'une manière négligeable, et
que la réaction du ou des précurseurs gazeux soit, à chaque stade de l'infiltration, limitée de telle sorte que, lors de la traversée de la zone de réaction, pas plus de 50 %, de préférence 10 à 25 %, du ou des précurseurs gazeux amenés dans le gaz, formant une phase solide, se déposent sous forme d'une phase solide dans la structure poreuse, et
que l'envoi du gaz sur la structure poreuse a lieu dans au moins un empilement vertical, disposé dans la direction verticale entre un côté entrée et un côté sortie de la zone de réaction, constitué de couches annulaires superposées, à travers des fentes périphériques verticales (A, B) constituées d'au moins une fente périphérique annulaire, radialement extérieure, (A), et d'au moins une fente périphérique annulaire, radialement intérieure, (B), tout comme de fentes transversales (C), courant entre les couches perpendiculairement à la direction verticale et de fentes terminales transversales (D, E) entre le côté entré et le côté sortie de la zone de réaction et la couche de l'empilement qui en est voisine, les fentes transversales et les fentes terminales étant ouvertes vers les fentes périphériques (A, B), et chacune des fentes périphériques présentant une largeur de fente qui est constante au moins dans la direction périphérique de l'empilement, et la fente périphérique extérieure étant ouverte vers le côté entrée et vers le côté sortie de la zone de réaction, et la fente périphérique intérieure étant fermée vers le côté entrée et vers le côté sortie, le rapport entre la largeur de fente de la fente périphérique radialement intérieure (B) et la largeur de fente de la fente périphérique radialement extérieure (A) étant supérieur à 1 et inférieur ou égal à 20, et le rapport entre la largeur de fente des fentes transversales (C) et celle de la fente périphérique radialement extérieure étant de 0,25 à 12.

2. Procédé selon la revendication 1, **caractérisé en ce que** le rapport entre la largeur de fente de la fente périphérique radialement intérieure (B) et la largeur de fente de la fente périphérique radialement extérieure (A) est de 2 à 10.

3. Procédé selon la revendication 1 ou 2, dans lequel le rapport entre la largeur de fente des fentes transversales (C) et la largeur de fente de la fente périphérique radialement extérieure (A) est de 0,5 à 10, de préférence de 0,5 à 5.

4. Procédé selon l'une des revendications 1 à 3, dans lequel le rapport entre la largeur de fente de la fente périphérique radialement intérieure (B) et la largeur de fente des fentes transversales (C) est compris dans la plage de 1 à 5.

5. Procédé selon l'une des revendications 1 à 4, dans lequel une proportion globale entre largeurs de fente (A:B:C) largeur de fente de la fente périphérique radialement extérieure (A) : largeur de fente de la fente périphérique radialement intérieure (B) : largeur de fente de chacune des fentes transversales (C), est comprise dans la plage de 1:2:05 à 1:10:5.

6. Procédé selon l'une des revendications 1 à 5, dans lequel la fente terminale côté sortie (E) a une largeur de fente qui est supérieure à la largeur de fente de chacune des fentes transversales (C).

7. Procédé selon la revendication 6, dans lequel le rapport entre la largeur de fente de la fente terminale côté sortie (E) et la largeur de fente de chacune des fentes transversales (C) est de 1,5 à 2,5.

8. Procédé selon l'une des revendications 1 à 7, dans lequel le gaz est envoyé à la fente périphérique radialement extérieure (A) en passant par une fente annulaire d'entrée (I) ayant un diamètre qui augmente d'un orifice d'entrée central du gaz à la fente périphérique radialement extérieure (A), et est évacué de la fente annulaire radialement extérieure (A) par une fente annulaire de sortie (O) ayant un diamètre qui diminue de la fente périphérique radialement extérieure (A) à un orifice de sortie central.

9. Procédé selon la revendication 8, dans lequel le ou les précurseurs gazeux sont préchauffés dans la fente annulaire d'entrée (F).

10. Procédé selon l'une des revendications 1 à 9, dans lequel l'envoi du gaz sur la structure poreuse est réalisé dans plusieurs empilements équivalents, disposés les uns à côté des autres, chacun des empilements étant entouré d'une paroi de réacteur par laquelle est délimitée au moins la fente périphérique annulaire extérieure (A) de chacun des empilements.

11. Procédé selon l'une des revendications 1 à 10, qui est mis en oeuvre sous forme d'un procédé en circuit fermé, dans lequel un effluent gazeux, qui est constitué du sous-produit libéré lors de la réaction limitée du gaz précurseur et de la partie n'ayant pas réagi du gaz précurseur, est soutiré de la zone de réaction dans une installation de préparation, dans laquelle le sous-produit est de nouveau préparé pour donner un gaz précurseur renouvelé, et l'effluent gazeux ainsi de nouveau préparé est renvoyé à la zone de réaction.

12. Procédé selon l'une des revendications 1 à 11, qui est utilisé pour l'infiltration en phase gazeuse de carbone (C) par réaction de méthane (CH₄) sur une plage de températures de 900 à 1200°C sous une pression de 50 à 300 mbar, le temps de séjour du gaz dans la zone de réaction étant de 0,01 à 1 seconde.

13. Procédé selon la revendication 12, dans lequel on évacue de la zone de réaction un effluent gazeux qui contient principalement du méthane, ainsi que de l'hydrogène, l'effluent gazeux étant envoyé dans une installation de méthanisation, dans laquelle l'hydrogène (H₂) est traité pour donner du méthane (CH₄), et est renvoyé dans la zone de réaction en même temps que le méthane évacué et le méthane frais.

14. Procédé selon la revendication 13, dans lequel on évacue de la zone de réaction un effluent gazeux composé de méthane (CH₄) et d'hydrogène (H₂), qui contient 55 à 75 % de méthane (CH₄) et 24 à 44 % d'hydrogène (H₂), et/ou dans lequel le traitement de l'hydrogène est réalisé par sa réaction avec du dioxyde de carbone (CO₂) et/ou du monoxyde de carbone (CO), et/ou dans lequel on envoie en outre de l'hydrogène (H₂) et de l'eau (H₂O) à l'effluent gazeux dans l'installation de méthanisation.

15. Procédé selon l'une des revendications 13 et 14, dans lequel le gaz renvoyé dans la zone de réaction contient au moins 94 % de méthane (CH₄) et jusqu'à 6 % d'hydrogène (H₂).
